(19) Europäisches Patentamt
European Patent Office
Office européen des brevets

(11) **EP 4 658 029 A1**

(12) **EUROPEAN PATENT APPLICATION**
published in accordance with Art. 153(4) EPC

(43) Date of publication:
**03.12.2025 Bulletin 2025/49**

(51) International Patent Classification (IPC):
*H10F 77/14* (2025.01)    *H10F 77/20* (2025.01)
*H10F 10/00* (2025.01)

(21) Application number: **25724594.4**

(22) Date of filing: **26.01.2025**

(86) International application number:
**PCT/CN2025/075167**

(87) International publication number:
**WO 2025/218309 (23.10.2025 Gazette 2025/43)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **16.04.2024 CN 202410461849**

(71) Applicant: **Longi Green Energy Technology Co.,
Ltd.
Xi'an, Shaanxi 710100 (CN)**

(72) Inventors:
• **JIN, Yupeng
Xi'an, Shaanxi 710100 (CN)**
• **YU, Long
Xi'an, Shaanxi 710100 (CN)**
• **TONG, Hongbo
Xi'an, Shaanxi 710100 (CN)**

(74) Representative: **Pfenning, Meinig & Partner mbB
Patent- und Rechtsanwälte
Theresienhöhe 11a
80339 München (DE)**

(54) **SOLAR CELL AND PHOTOVOLTAIC MODULE**

(57) The present application provides a solar cell, including: a silicon substrate, and a plurality of fingers formed on a surface of the silicon substrate. The silicon substrate is doped with antimony; and when a grid line density of fingers with the same polarity on a unit length in a direction perpendicular to the plurality of fingers is n/cm and a concentration of antimony in the silicon substrate is a atom/cm$^3$, n and a meet the following relationship: n≥35-klg a, where k is less than or equal to 2. The present application further provides a photovoltaic module formed by the solar cell provided in the present application.

FIG. 1

EP 4 658 029 A1

**Description**

The present application claims priority to Chinese Patent Application No. 202410461849.2 filed on April 16, 2024, which is incorporated herein by reference in its entirety.

**TECHNICAL FIELD**

The present application relates to the field of photovoltaic technologies, and specifically, to a solar cell and a photovoltaic module including the solar cell.

**BACKGROUND**

In existing silicon solar cells, a silicon wafer having an N-type or P-type doped substrate is generally used as a substrate. P-type and N-type semiconductors are respectively formed at different positions of the silicon wafer, and electrodes are then formed on regions of the P-type and N-type semiconductors, to form a cell. When light is incident to the substrate of the silicon cell, electron hole pairs are generated. Free electron hole pairs are separated through carriers, so that electrons are aggregated around N electrodes, and holes are aggregated around P electrodes. An external circuit is connected to the electrodes, so that a current may be outputted. In the related art, a P-type semiconductor substrate or an N-type semiconductor substrate is generally used as a photovoltaic semiconductor substrate. The P-type semiconductor substrate is generally doped with a boron element or a gallium element. The N-type semiconductor substrate is generally doped with a phosphorus element.

Due to an advantage of a long minority carrier diffusion length of the N-type semiconductor substrate, when the N-type semiconductor substrate is used for power generation of the silicon solar cell, compared with the P-type semiconductor substrate, more carriers may be collected, so that the silicon solar cell corresponding has higher efficiency. The N-type semiconductor substrate is generally doped with a phosphorus element. In the photovoltaic field, research on using a silicon wafer doped with an Sb element as a silicon substrate to prepare a solar cell and a photovoltaic module has been started. However, for the solar cell formed by using the silicon substrate doped with the Sb element, cell efficiency needs to be further optimized and improved.

**SUMMARY**

In view of the foregoing problems, the present application is intended to alleviate the problems involved in the related art. Through in-depth research in the present application, a relationship between a concentration of Sb and a grid line density is determined, and the concentration of Sb and a quantity of grid lines in the silicon substrate are matched and combined, thereby improving a transmission effect and cell efficiency of a solar cell. The present application provides the following solutions:

According to a first aspect, a solar cell is provided, including:

a silicon substrate, and a plurality of fingers formed on a surface of the silicon substrate, where the plurality of fingers extend in the same direction;
the silicon substrate is doped with antimony; and
when a grid line density of fingers with the same polarity in a direction perpendicular to the extending direction of the plurality of fingers is n/cm and a concentration of antimony in the silicon substrate is a atom/cm$^3$, n and a meet the following relationship:

$$n \geq 35 - k \lg a,$$

where
k is a constant less than or equal to 2.

When a thickness of the silicon substrate of the solar cell is b μm, n meets the following relationship:

$$n \geq 35 - k \lg a + \frac{c}{b},$$

where

c is a constant and a value is 50 μm.

n and a further meet the following relationship:

$$n \leq 35 - \lg a.$$

When the solar cell is a double-sided contact solar cell, k=2.

When the solar cell is a back contact solar cell, k=1.9.

The surface of the silicon substrate includes an electron collection region, a hole collection region, and an isolating region located between the electron collection region and the hole collection region; and when a depth of the isolating region is d μm, n meets the following relationship:

$$n \geq 35 - 1.9 \lg a + \frac{c}{b-d}.$$

The depth of the isolating region is a height difference corresponding to an average depth from a bottom of a region having a higher absolute height of the electron collection region and the hole collection region to a bottom of the isolating region, and the bottom of the isolating region is a surface of the silicon substrate corresponding to the isolating region; and

when the solar cell includes an interface passivation layer, a bottom of the electron collection region or a bottom of the hole collection region is a surface of the interface passivation layer close to the silicon substrate.
a ranges from 1E13 to 1E18.

A width of each of the plurality of fingers ranges from 10 μm to 200 μm.

According to a second aspect, a photovoltaic module is provided, including the solar cell according to any one of the foregoing description.

Technical effects

In the present application, matching and combination can be performed based on a structure of the cell and a concentration of Sb and a quantity of fingers in the silicon substrate of the cell, that is, the foregoing formula 1 can be met, so that a transverse transmission effect of carriers may be effectively improved. In this way, good cell efficiency Eta and a good open-circuit voltage can be obtained, a short-circuit current and a fill factor are also excellent, so that the efficiency of the cell can be effectively improved.

**BRIEF DESCRIPTION OF THE DRAWINGS**

FIG. 1 is a schematic diagram of a back contact solar cell;
FIG. 2 is a pattern of back electrodes of a back contact solar cell;
FIG. 3 is a pattern of back electrodes of a double-sided contact solar cell;
FIG. 4 is a schematic diagram of a back contact solar cell according to an embodiment of the present application;
FIG. 5 is a schematic diagram of a back contact solar cell according to an embodiment of the present application;
FIG. 6 is a schematic diagram of a back contact solar cell according to an embodiment of the present application;
FIG. 7 is a schematic diagram of a double-sided contact solar cell according to an embodiment of the present application;
FIG. 8 is a trend chart of cell efficiency of Table 1;
FIG. 9 is a trend chart of cell efficiency of Table 2;
FIG. 10 is a trend chart of cell efficiency of Table 3;
FIG. 11 is a trend chart of cell efficiency of Table 4; and
FIG. 12 is a schematic diagram of a fitting curve of a doping concentration of antimony and an inflection point grid line density.

Description of reference numerals:

1: First electrode; 2: Passivation layer; 3: Semiconductor layer; 9: Interface passivation layer; 4: Silicon substrate; 5: Second electrode; 6: Isolating region; 7: Hole collection region; and 8: Electron collection region.

**DETAILED DESCRIPTION**

The following embodiments of the present application are merely used for describing embodiments implementing the present application and cannot be construed as a limitation to the present application. Any other changes, modifications, replacements, combinations, or simplifications made without departing from the spirit essence and principle of the present application shall be considered as equivalent replacement manners and all fall within the protection scope of the present application.

Specific embodiments of the present application will be described in further detail below. It should be understood that, the present application can be implemented in various manners and should not be limited by the embodiments described herein. On the contrary, the embodiments are provided, so that the present application can be understood more thoroughly and a scope of the present application can be completely conveyed to a person skilled in the art.

It should be noted that, some terms are used in this specification and the claims to designate specific components. A person skill in the art should understand that, a technician may designate the same component with different terms. In this specification and the claims, components are distinguished between each other by using differences in function as a criterion instead of difference in terms. For example, "include" or "comprise" mentioned throughout this specification and the claims is an open term and therefore should be explained as "include but not limited to". The subsequent description of this specification is preferred embodiments of the present application, but the description is provided for describing general principle of this specification and is not intended to limit a scope of the present application. The protection scope of the present application shall be subject to the appended claims.

As used in this specification, "one" or "a" may indicate one or more than one. As used in the claims, when used with the term "include" together, the term "one" or "a" may indicate one or more than one.

The term "or" used in the claims is used for representing "and/or", unless otherwise specified that the term only includes an alternate solution or alternate solutions are mutually exclusive, although content in the present disclosure supports that the term only indicates an alternate solution and the definition of "and/or". As used in this specification, "another" may indicate at least second or more.

In the present application, a silicon substrate involved in the following content of the present application is not further limited, and may be a silicon substrate (or may be referred to as a naked silicon wafer) obtained through machine processing and slicing after a silicon ingot is drawn. In the present application, the silicon substrate may alternatively be a structure including a silicon substrate and at least including a partial doped region and removed and recycled from a cell assembly, provided that the structure has a specific shape and can be presented in the shape of a sheet, that is, a size of the structure on a plane is greater than a size of the structure on a plane perpendicular to the plane, for example, flat-shaped or plate-shaped. A size of the structure including the silicon substrate and at least including the partial doped region is also not limited, and the silicon substrate or the structure including the silicon substrate and at least including the partial doped region may be in any size, for example, a part of the removed silicon substrate or structure including the silicon substrate and at least including the partial doped region obtained by recycling and removing another layer structure from the cell assembly. In addition, a person skill in the art may understand that, during removal, if the structure at least including the partial doped region is damaged, provided that the partial doped region still exists, the structure should also be understood as corresponding to the solar cell mentioned in the cell of the present application. For example, in an embodiment, a length of at least one side of the structure including the silicon substrate and at least including the partial doped region in the present application is greater than 156 mm, for example, may be 158±2 mm, (160±2) mm, (165±2) mm, (170±2) mm, (175±2) mm, (180±2) mm, (185±2) mm, 190±2 mm, (195±2) mm, (200±2) mm, (205±2) mm, (210±2) mm, (215±2) mm, (220±2) mm, (225±2) mm, (230±2) mm, (235±2) mm, (240±2) mm, (245±2) mm, (250±2) mm, (255±2) mm, (260±2) mm, (265±2) mm, (270±2) mm, (275±2) mm, or any range formed by the values. For example, in an embodiment, a thickness of the silicon substrate or the structure including the silicon substrate and at least including the partial doped region of the present application ranges from 70 $\mu$m to 170 $\mu$m, for example, may be 80 $\mu$m, 90 $\mu$m, 100 $\mu$m, 110 $\mu$m, 120 $\mu$m, 130 $\mu$m, 140 $\mu$m, 150 $\mu$m, or 160 $\mu$m. In an embodiment, the size of the part of the removed structure including the silicon substrate and at least including the partial doped region obtained by recycling and removing another layer structure may be less than the foregoing size, provided that a doping concentration of a detected doping element can be equal to a parameter involved in the present application.

The silicon substrate in the present application includes a doping element antimony, and the doping element generally already exists when the naked silicon wafer is prepared, so that the doping concentration of the doping element of the silicon substrate is approximately uniform in various portions of the entire silicon substrate, that is, an average concentration is approximately the same.

In an embodiment of the present application, a total element concentration of antimony in a unit volume in the silicon substrate of the present application is a atom/cm$^3$. Preferably, a ranges from 1E13 to 1E18.

A person skilled in the art may understand that, the silicon substrate in the present application may further include another doping element to form a doped region with a different function. Different regions may be formed on the silicon substrate based on different structures of the cell, for example, a hole collection region and an electron collection region may be formed on a side of the silicon substrate, or a hole collection region and an electron collection region are respectively formed on two sides of the silicon substrate. A person skilled in the art can completely form the hole collection region and/or the electron collection region on the silicon substrate according to a known method, quantities and sizes of the hole collection regions and the electron collection regions are not limited, and the person skilled in the art may design according to a structure, a size, and a requirement of an actual cell.

In the present application, whether an element exists in the silicon substrate and the doped region may be detected through methods such as SIMS, SSMS, ICP-MS, GDMS, or ECV, and preferably, a metal element is detected through methods such as SIMS or SSMS. In the present application, the solar cell is also referred to as a cell.

In the present application, the concentration of the doping element (antimony) in the silicon substrate may be detected through any method known to a person skilled in the art, and the person skilled in the art may select based on a requirement. For example, the concentration may be detected through methods such as SIMS, SSMS, ICP-MS, GDMS, or ECV, and preferably, detected through methods such as SIMS or SSMS. A person skilled in the art may understand that, the concentration of the doping element may be a concentration of the doping element at any position on a surface of the silicon substrate or in the middle or inside the silicon substrate, and certainly, may alternatively be an average value of concentrations of the doping element at a plurality of positions on the silicon substrate or an average value of concentrations of the doping element on the whole silicon substrate. A person skilled in the art may select any position to perform detection based on an actual situation according to detection conditions and a used instrument, or may detect a plurality of positions and calculate an average value of concentrations of the doping element at the plurality of positions as the concentration of the doping element in the silicon substrate. In an embodiment, the concentration of the doping element in the silicon substrate is an average value detected in the thickness of the silicon substrate. For example, the concentration of the doping element in the silicon substrate is detected in the thickness direction by using methods such as SIMS or SSMS, and an average value of concentrations of the doping element in the thickness direction is calculated. In the present application, when the concentration of antimony is mentioned, the concentration generally refers to an average concentration of antimony. However, antimony is generally uniformly doped in the silicon substrate, so that the average concentration may alternatively be a concentration at any position.

In an embodiment of the present application, only antimony is doped in the silicon substrate of the present application as a VA doping element to replace a phosphorus element for doping. In this case, a person skilled in the art may understand that the silicon substrate may contain other elements depending on different raw materials of the silicon substrate, for example, any one, two, or three of phosphorus, gallium, or germanium, but only antimony is actively doped as the VA doping element to replace the phosphorus element for doping. Generally, when a single element is doped in the silicon substrate, lattice distortion of crystalline silicon may be caused, leading to various detects of a heavily doped region. However, in an embodiment of the present application, the silicon substrate has antimony, so that an IIIA and a VA may be further doped to form co-doping, and the lattice distortion of crystalline silicon caused by doping of a single element may be further overcome, thereby avoiding various defects of the heavily doped region.

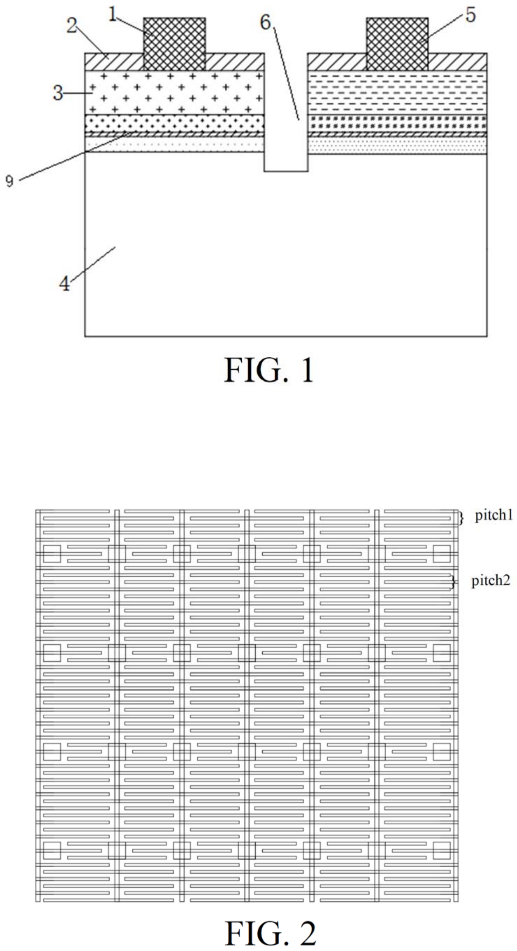

FIG. 1 shows a schematic diagram of a typical back contact solar cell. Generally, the solar cell includes a silicon substrate 4, a positive electrode, that is, a first electrode 1, and a negative electrode, that is, a second electrode 5, where the positive electrode forms contact with a P-type semiconductor, and the negative electrode forms contact with an N-type semiconductor. In a case with illumination, an external circuit is connected to the electrodes, so that the entire solar cell may output a current. In FIG. 1, a region formed by the P-type semiconductor on a left side is a hole collection region, and a region formed by the N-type semiconductor on a right side is an electron collection region.

Further, as shown in FIG. 1, an interface passivation layer 9 (also may be referred to as a tunneling layer) is arranged on a surface of the silicon substrate 4, and a thickness of the interface passivation layer 9 ranges from 0.1 nm to 5 nm, for example, may be 0.1 nm, 0.5 nm, 1 nm, 2 nm, 3 nm, 4 nm, or 5 nm; and a material of the interface passivation layer 9 may be a material commonly used by a person skilled in the art, and according to different specific types of cells, may be selected from materials such as silicon oxide, aluminum oxide, silicon nitride, or intrinsic amorphous silicon.

Further, a semiconductor layer 3 is arranged on a side of the interface passivation layer 9 away from the silicon substrate 4. A material of the semiconductor layer 3 may be a material commonly used by a person skilled in the art, and according to different specific types of cells, may be selected from one or more of polycrystalline silicon, amorphous silicon, or microcrystalline silicon. The semiconductor layer 3 may be a plurality of mixed members or stacked members. In the cell structure shown in FIG. 1, the hole collection region and the electron collection region may be isolated through an isolating region 6. Further, a passivation layer 2 may be further arranged on the semiconductor layer 3.

The silicon substrate 4 in the present application may include a part of another doped region, and the doped region may be formed by being doped into a silicon wafer through the interface passivation layer 9 by using the semiconductor layer 3; or may be formed through direct doping.

In the present application, in addition to being doped with antimony, the silicon substrate 4 may be further doped with another element, for example, an IIIA element or a VA element, where the IIIA element is, for example, boron, aluminum, gallium, indium, or thallium, and the VA element is, for example, nitrogen, phosphorus, arsenic, antimony, or bismuth.

In an embodiment, a partial region of the silicon substrate 4 is doped with a phosphorus element, and a partial region is doped with a boron element. In an embodiment, the interface passivation layer 9 is a layer having a passivation function and allowing the doping element to pass, for example, may be a tunneling layer.

FIG. 2 shows a pattern of back electrodes of an interdigitated back contact (IBC) solar cell, that is, a two-dimensional structural diagram of electrodes of the IBC solar cell. Hole collection regions and electron collection regions arranged in cross in an interdigitated shape are formed on a back surface of the silicon substrate, and positive electrodes and negative electrodes are also arranged in the interdigitated shape on the back surface of the cell to form a back junction back contact solar cell. In the present application, a type of a cell used in the IBC solar cell is not limited, provided that first emitters (that is, the electron collection regions) and second emitters (that is, the hole collection regions) are arranged in cross on the back surface.

In the present application, a front surface of the silicon substrate is a surface of a side facing sunlight under a normal working condition of the cell, and a back surface is a surface of another side of the silicon substrate opposite to the front surface.

As shown in FIG. 2, a plurality of fingers are formed on the back surface of the silicon substrate, and the plurality of fingers extend in the same direction (a left-right direction in FIG. 2). In FIG. 2, in a direction (an up-down direction in FIG. 2) perpendicular to the extending direction of the plurality of fingers, a center interval between IBC fine grid lines with the same polarity is represented by pitch below. Using FIG. 2 as an example, a center interval between fine grid lines of the first electrode is pitch1, a center interval between fine grid lines of the second electrode is pitch2, and pitch 1 =pitch2=pitch.

In the present application, in a direction perpendicular to the plurality of fingers (that is, the direction perpendicular to the extending direction of the plurality of fingers), a grid line density of fingers with the same polarity is n/cm. A person skilled in the art may determine an average quantity of fingers in per centimeter through visual observation, for example, the average quantity may be measured through a counting method. Alternatively, a total quantity of fingers arranged on the entire silicon substrate may be determined through counting, and the total quantity is divided by a length (in the direction perpendicular to the plurality of fingers) of the entire silicon substrate to determine the grid line density. For the back contact solar cell, since fingers with different polarities are arranged on the same side, the total quantity generally needs to be further divided by 2 to obtain an average quantity of fingers with the same polarity. In addition, the grid line density may be alternatively obtained according to a quantity of fingers with the same polarity and a cell length in the direction perpendicular to the plurality of fingers.

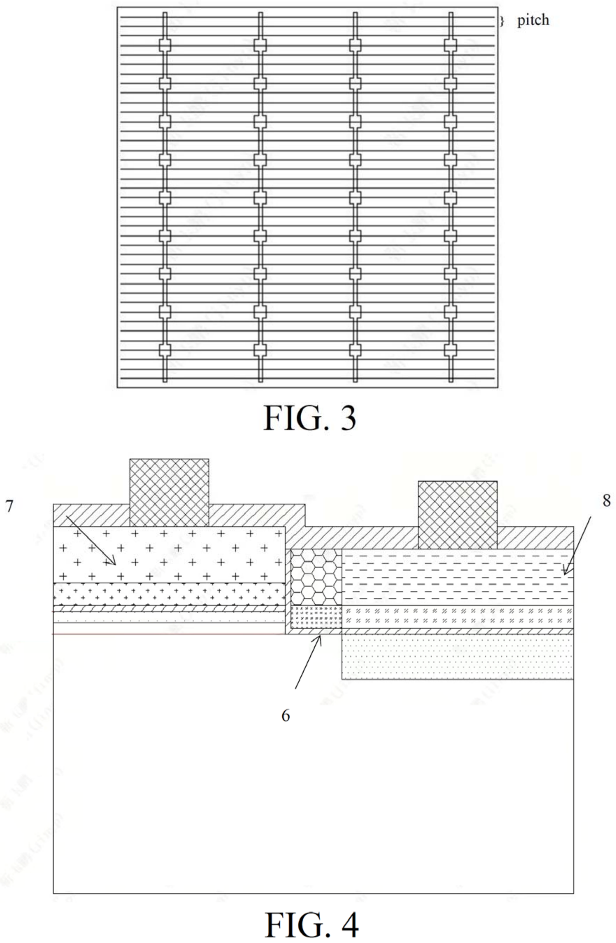

FIG. 3 shows a pattern of back electrodes of a double-sided contact solar cell. In the cell structure in FIG. 3, electrodes with the same polarity are arranged on the entire surface of a side of the silicon substrate, and the electrodes with the same polarity include fingers that are parallel or approximately parallel to each other, that is, fine grid lines. Electrodes with an opposite polarity are formed on the entire surface of the other side of the silicon substrate. In addition, the electrodes may further include main grid lines perpendicular to the fine grid lines shown in FIG. 3. As shown in FIG. 3, a center interval between fine grid lines with the same polarity is pitch.

Similar to the back contact electrodes, a person skilled in the art may measure the distance pitch between adjacent fingers and a total length of the cell in the direction perpendicular to the fingers, and perform calculation by dividing the total length by the distance pitch. In addition, the person skilled in the art may also fully understand that, the method for calculating or measuring the quantity is merely listed for an example, and the person skilled in the art may fully calculate the quantity according to an actual situation.

In the present application, when the grid line density of the fingers with the same polarity in the direction perpendicular to the fingers on a unit length is calculated, a person skilled in the art may also be clear that the calculation is merely performed for a region on which fingers are arranged. If fingers are uniformly arranged on the silicon substrate, the entire silicon substrate may be used as a basis for calculating the fingers, and if fingers are merely arranged on a partial region of the silicon substrate of the cell, the grid line density on the unit length should be calculated by using the partial region to measure the total length of the region on which the fingers are arranged.

A width of each of the plurality of fingers ranges from 10 μm to 200 μm.

It is found by the inventor through in-depth research that, in an embodiment of the present application, a cell of the present application includes: a silicon substrate, and a plurality of fingers formed on a surface of the silicon substrate, where the silicon substrate is doped with antimony; and in a direction perpendicular to an extending direction of the plurality of fingers, a grid line density of fingers with the same polarity on a unit length is n/cm. The grid line density n and a concentration a atom/cm$^3$ of antimony in the silicon substrate meet the following relationship:

$$n \geq 35 - k\lg a \qquad \text{Formula 1}$$

In the present application, the finger is a grid line configured to collect carriers, and is generally also referred to as a fine grid line.

A form of the cell is not limited in the present application, and the present application may be applicable to various types of solar cells, including an aluminum back-surface-field (Al-BSF) cell, a passivated emitter and rear cell (PERC), or a metal wrap through (MWT) cell; or a passivated emitter and rear locally-diffused (PERL) cell, a passivated emitter and rear totally diffused (PERT) cell, an emitter-wrap-through (EWT) cell, a tunnel oxide passivated contact solar cell (TOPCon), an interdigitated back contact (IBC) cell, a heterojunction with intrinsic thin-film (HJT/HIT) cell, or a heterojunction back contact (HBC) cell.

In an embodiment, if the cell is a double-sided contact cell, designs of the solution of the present application for fingers of electrodes on front and back surfaces are all suitable, and a design may be performed according to the solution of the present application, where data in this embodiment is provided by using grid lines on the front surface as an example.

In some embodiments, the cell may be a cell at least partially including a structure of a TOPCon, for example, a TOPCon cell, a local TOPCon cell, a back contact hybrid cell, or a TBC cell, or may be a heterojunction with intrinsic thin-film (HJT/HIT) cell or a heterojunction back contact (HBC) cell.

In an embodiment, k is a constant less than or equal to 2, and for example, may be 1.5, 1.6, 1.7, 1.8, 1.9, or 2.0.

For various types of cells, Formula 1 can be met by effectively controlling a quantity of the fingers, so that a transverse transmission effect of carriers may be effectively improved. In this way, good cell efficiency Eta and a good open-circuit voltage can be obtained, and a short-circuit current and a fill factor are also excellent, so that the efficiency of the cell can be effectively improved.

In an embodiment, for the thickness of the silicon substrate in different solar cells, the quantity n of the fingers with the same polarity on the unit length (that is, the grid line density n/cm) is further corrected, and when the thickness of the silicon substrate is b μm, the grid line density n and the concentration a of antimony in the silicon substrate meet the following relationship:

$$n \geq 35 - k \lg a + \frac{c}{b} \qquad \text{Formula 2}$$

A constant c is 50 μm. Based on Formula 2, a thinner silicon substrate indicates larger influence of transverse transmission resistance of carriers on a grid line design, and a larger quantity of grid lines is required to improve the cell performance. When the thickness b of the silicon substrate ranges from 50 μm to 100 μm or ranges from 100 μm to 180 μm, different value ranges may be calculated based on Formula 2.

In an embodiment, n meets the following relationship:

$$n \leq 35 - \lg a \qquad \text{Formula 3}$$

Generally, a larger quantity of grid lines indicates a larger contact area between metal and a silicon semiconductor, and carriers in the silicon substrate are more easily recombined. Therefore, it is not beneficial to maximize the grid line density and the grid line density has a specific upper limit. In addition, there is a higher carrier recombination rate (the recombination rate is measured by using a reverse saturation current density) at an electrode, a larger value of the recombination rate indicates severer recombination and lower cell efficiency, so that it is not beneficial to maximize the grid line density and the grid line density has a specific upper limit. In addition, a larger quantity of grid lines indicates a severer light shielding effect of the cell correspondingly. Therefore, when n meets Formula 1 and Formula 3, that is, 35-klg a≤n≤35-lg a, the transverse transmission effect of carriers and influence of light shielding on the cell efficiency may be effectively balanced, and better cell efficiency is obtained.

In an embodiment, the grid line density in the foregoing Formula 1, Formula 2, and Formula 3 of the present application may be applicable to fine grid lines on front and back surfaces of a double-sided contact cell, including a PN junction side and a high-low junction side; and may also be applicable to grid lines on a back surface of a BC cell, including a back positive fine grid line and a back negative fine grid line.

In an embodiment, for the double-sided contact cell, when the positive electrode and the negative electrode of the cell are distributed on two different surfaces of the cell, k is preferably 2.

The double-sided contact cell is a cell collecting carriers to the same surface or different surfaces through doped regions on different surfaces. For example, the positive electrode and the negative electrode are directly located on two sides, or electrons and holes are led out from two sides respectively, but finally the positive electrode and the negative electrode are located on the same surface of the cell.

In an embodiment of the present application, the double-sided contact cell may be a metal wrap through (MWT) cell or an emitter-wrap-through (EWT) cell.

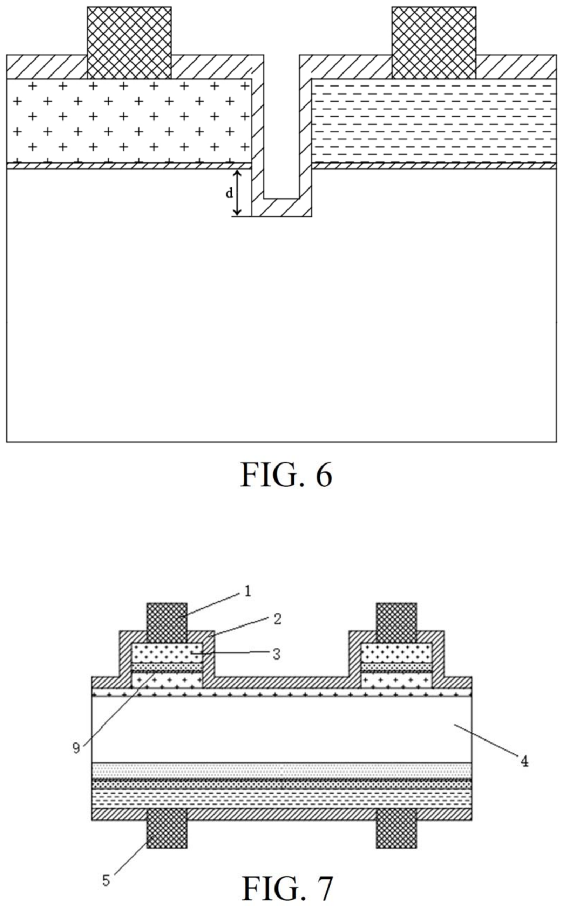

In an embodiment of the present application, the double-sided contact cell is a TOPCon cell. FIG. 7 shows a typical structure of a double-sided contact cell involved in the present application. A semiconductor layer 3 is arranged on a side of an interface passivation layer 9 facing away from a silicon substrate 4. Further, a passivation layer 2 may be further arranged on the semiconductor layer 3. Further, the solar cell includes a silicon substrate 4, a first electrode 1, and a second electrode 5. In FIG. 7, a region formed by the P-type semiconductor in an upper portion is a hole collection region, and a region formed by the N-type semiconductor in a lower portion is an electron collection region.

In an embodiment, for the back contact cell, when the positive electrode and the negative electrode of the cell are arranged on the same surface of the cell, k=1.9. It is found by the inventor of the present application through a large quantity of experiments that, when k is 1.9 for the back contact cell, a result is more accurate.

In an embodiment of the present application, the back contact cell is a back contact hybrid cell.

In an embodiment of the present application, the back contact cell is a TBC cell.

In an embodiment of the present application, the back contact cell is a heterojunction back contact cell.

In an embodiment, for the back contact cell, one side of the cell generally includes an electron collection region, a hole collection region, and an isolating region located between the electron collection region and the hole collection region; and when a depth of the isolating region between the electron collection region and the hole collection region of the cell is d $\mu$m, n meets the following relationship:

$$\mathrm{n} \geq 35 - 1.9 \lg a + \frac{c}{b-d} \qquad \text{Formula 4}$$

The depth of the isolating region is a height difference corresponding to an average depth from a bottom of a region having a higher absolute height of the electron collection region and the hole collection region to a bottom of the isolating region, namely, a vertical depth from an interface (that is, a surface of the silicon substrate) between a tunneling layer and a substrate of the hole collection region or the electron collection region to a deepest point of the isolating region, or a vertical depth of a higher region to a deepest point of the isolating region if heights of the hole collection region and the electron collection region are different.

The isolating region is an electrically insulated region (or may be referred to as a gap region) introduced between the hole collection region and the electron collection region, so that transverse direct contact between the hole collection region and the electron collection region is avoided. It is not difficult for a person skilled in the art to understand that, the height difference d is a vertical height difference corresponding to the average depth from the bottom of the region having a higher absolute height of the electron collection region and the hole collection region to the bottom of the isolating region. When the solar cell includes an interface passivation layer, the bottom of the electron collection region or the bottom of the hole collection region is a surface of the interface passivation layer close to the silicon substrate.

In an embodiment, a structure of the back contact cell is shown in FIG. 4, where a hole collection region 7 and an electron collection region 8 are isolated through an isolating region 6, where the hole collection region 7 is a higher region of the two regions. Therefore, as shown in FIG. 4, the height different is a difference between the bottom of the electron collection region 8 and the bottom of the isolating region 6.

In an embodiment, the hole collection region, the electron collection region, and the isolating region of the solar cell involved in the present application are located at the same height, that is, depths of the regions are the same, so that there is no height difference.

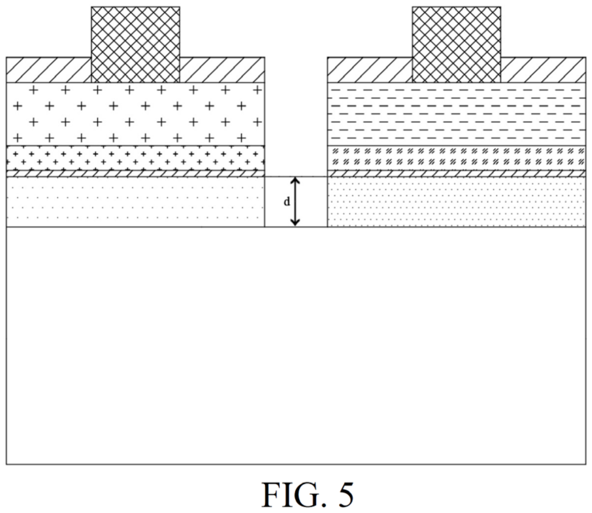

In an embodiment, the present application provides a structure of a solar cell, and the structure is shown in FIG. 5, where depths of the hole collection region and the electron collection region are the same, and the height difference corresponding to the average depth from the bottom of any one of the hole collection region and the electron collection region to the bottom of the isolating region is d.

The present application provides a schematic structural diagram of a solar cell, as shown in FIG. 6, depths of the hole collection region and the electron collection region are the same, and the height difference corresponding to the average depth from the bottom of any one of the hole collection region and the electron collection region to the bottom of the isolating region is d.

For a back contact cell with the height difference d, if the foregoing Formula 4 (k=1.9) is met, with such a setting, a transverse transmission effect and a longitudinal transmission effect of carriers and influence of light shielding on the cell efficiency may be effectively balanced.

In an embodiment, the concentration a of antimony ranges from 1E13 atom/cm$^3$ to 1E18 atom/cm$^3$.

For example, the concentration a of antimony may be 1E13 atom/cm$^3$, 1E14 atom/cm$^3$, 1E15 atom/cm$^3$, 1E16 atom/cm$^3$, 1E17 atom/cm$^3$, or 1E18 atom/cm$^3$. For example, the concentration may be 2E13 atom/cm$^3$, 3E13 atom/cm$^3$, 4E13 atom/cm$^3$, 5E13 atom/cm$^3$, 6E13 atom/cm$^3$, 7E13 atom/cm$^3$, 8E13 atom/cm$^3$, 9E13 atom/cm$^3$, 1E14 atom/cm$^3$, 4E+14 atom/cm$^3$, 4.1E+14 atom/cm$^3$, 4.2E+14 atom/cm$^3$, 4.3E+14 atom/cm$^3$, 4.4E+14 atom/cm$^3$, 4.5E+14 atom/cm$^3$, 4.6E+14 atom/cm$^3$, 4.7E+14 atom/cm$^3$, 4.8E+14 atom/cm$^3$, 4.9E+14 atom/cm$^3$, 5E+14 atom/cm$^3$, 5.1E+14 atom/cm$^3$, 5.2E+14 atom/cm$^3$, 5.3E+14 atom/cm$^3$, 5.4E+14 atom/cm$^3$, 5.5E+14 atom/cm$^3$, 5.6E+14 atom/cm$^3$, 5.7E+14 atom/cm$^3$, 5.8E+14 atom/cm$^3$, 5.9E+14 atom/cm$^3$, 6E+14 atom/cm$^3$, 6.1E+14 atom/cm$^3$, 6.2E+14 atom/cm$^3$, 6.3E+14 atom/cm$^3$, 6.4E+14 atom/cm$^3$, 6.5E+14 atom/cm$^3$, 6.6E+14 atom/cm$^3$, 6.7E+14 atom/cm$^3$, 6.8E+14 atom/cm$^3$, 6.9E+14 atom/cm$^3$, 7E+14 atom/cm$^3$, 7.1E+14 atom/cm$^3$, 7.2E+14 atom/cm$^3$, 7.3E+14 atom/cm$^3$, 7.4E+14 atom/cm$^3$, 7.5E+14 atom/cm$^3$, 7.6E+14 atom/cm$^3$, 7.7E+14 atom/cm$^3$, 7.8E+14 atom/cm$^3$, 7.9E+14 atom/cm$^3$, 8E+14 atom/cm$^3$, 8.1E+14 atom/cm$^3$, 8.2E+14 atom/cm$^3$, 8.3E+14 atom/cm$^3$, 8.4E+14 atom/cm$^3$, 8.5E+14 atom/cm$^3$, 8.6E+14 atom/cm$^3$, 8.7E+14 atom/cm$^3$,

8.8E+14 atom/cm$^3$, 8.9E+14 atom/cm$^3$, 9E+14 atom/cm$^3$, 9.1E+14 atom/cm$^3$, 9.2E+14 atom/cm$^3$, 9.3E+14 atom/cm$^3$, 9.4E+14 atom/cm$^3$, 9.5E+14 atom/cm$^3$, 9.6E+14 atom/cm$^3$, 9.7E+14 atom/cm$^3$, 9.8E+14 atom/cm$^3$, 9.9E+14 atom/cm$^3$, 1E+15 atom/cm$^3$, 1.1E+15 atom/cm$^3$, 1.2E+15 atom/cm$^3$, 1.3E+15 atom/cm$^3$, 1.4E+15 atom/cm$^3$, 1.5E+15 atom/cm$^3$, 1.6E+15 atom/cm$^3$, 1.7E+15 atom/cm$^3$, 1.8E+15 atom/cm$^3$, 1.9E+15 atom/cm$^3$, 2E+15 atom/cm$^3$, 2.1E+15 atom/cm$^3$, 2.2E+15 atom/cm$^3$, 2.3E+15 atom/cm$^3$, 2.4E+15 atom/cm$^3$, 2.5E+15 atom/cm$^3$, 2.6E+15 atom/cm$^3$, 2.7E+15 atom/cm$^3$, 2.8E+15 atom/cm$^3$, 2.9E+15 atom/cm$^3$, 3E+15 atom/cm$^3$, 3.1E+15 atom/cm$^3$, 3.2E+15 atom/cm$^3$, 3.3E+15 atom/cm$^3$, 3.4E+15 atom/cm$^3$, 3.5E+15 atom/cm$^3$, 3.6E+15 atom/cm$^3$, 3.7E+15 atom/cm$^3$, 3.8E+15 atom/cm$^3$, 3.9E+15 atom/cm$^3$, 4E+15 atom/cm$^3$, 4.1E+15 atom/cm$^3$, 4.2E+15 atom/cm$^3$, 4.3E+15 atom/cm$^3$, 4.4E+15 atom/cm$^3$, 4.5E+15 atom/cm$^3$, 4.6E+15 atom/cm$^3$, 4.7E+15 atom/cm$^3$, 4.8E+15 atom/cm$^3$, 4.9E+15 atom/cm$^3$, 5E+15 atom/cm$^3$, 5.1E+15 atom/cm$^3$, 5.2E+15 atom/cm$^3$, 5.3E+15 atom/cm$^3$, 5.4E+15 atom/cm$^3$, 5.5E+15 atom/cm$^3$, 5.6E+15 atom/cm$^3$, 5.7E+15 atom/cm$^3$, 5.8E+15 atom/cm$^3$, 5.9E+15 atom/cm$^3$, 6E+15 atom/cm$^3$, 6.1E+15 atom/cm$^3$, 6.2E+15 atom/cm$^3$, 6.3E+15 atom/cm$^3$, 6.4E+15 atom/cm$^3$, 6.5E+15 atom/cm$^3$, 6.6E+15 atom/cm$^3$, 6.7E+15 atom/cm$^3$, 6.8E+15 atom/cm$^3$, 6.9E+15 atom/cm$^3$, 7E+15 atom/cm$^3$, 7.1E+15 atom/cm$^3$, 7.2E+15 atom/cm$^3$, 7.3E+15 atom/cm$^3$, 7.4E+15 atom/cm$^3$, 7.5E+15 atom/cm$^3$, 7.6E+15 atom/cm$^3$, 7.7E+15 atom/cm$^3$, 7.8E+15 atom/cm$^3$, 7.9E+15 atom/cm$^3$, 8E+15 atom/cm$^3$, 8.1E+15 atom/cm$^3$, 8.2E+15 atom/cm$^3$, 8.3E+15 atom/cm$^3$, 8.4E+15 atom/cm$^3$, 8.5E+15 atom/cm$^3$, 8.6E+15 atom/cm$^3$, 8.7E+15 atom/cm$^3$, 8.8E+15 atom/cm$^3$, 8.9E+15 atom/cm$^3$, 9E+15 atom/cm$^3$, 9.1E+15 atom/cm$^3$, 9.2E+15 atom/cm$^3$, 9.3E+15 atom/cm$^3$, 9.4E+15 atom/cm$^3$, 9.5E+15 atom/cm$^3$, 9.6E+15 atom/cm$^3$, 9.7E+15 atom/cm$^3$, 9.8E+15 atom/cm$^3$, 9.9E+15 atom/cm$^3$, 1E+16 atom/cm$^3$, 1.1E+16 atom/cm$^3$, 1.2E+16 atom/cm$^3$, 1.3E+16 atom/cm$^3$, 1.4E+16 atom/cm$^3$, 1.5E+16 atom/cm$^3$, 1.6E+16 atom/cm$^3$, 1.7E+16 atom/cm$^3$, 1.8E+16 atom/cm$^3$, 1.9E+16 atom/cm$^3$, 2E+16 atom/cm$^3$, 3E+16 atom/cm$^3$, 4E+16 atom/cm$^3$, 5E+16 atom/cm$^3$, 6E+16 atom/cm$^3$, 7E+16 atom/cm$^3$, 8E+16 atom/cm$^3$, 9E+16 atom/cm$^3$, 1E+17 atom/cm$^3$, 2E+17 atom/cm$^3$, 3E+17 atom/cm$^3$, 4E+17 atom/cm$^3$, 5E+17 atom/cm$^3$, 6E+17 atom/cm$^3$, 7E+17 atom/cm$^3$, 8E+17 atom/cm$^3$, 9E+17 atom/cm$^3$, or any range formed by the values.

In the present application, an Sb element is doped in the silicon substrate, and defects are few due to low-concentration doping, so that charge mobility of the silicon substrate may be improved and resistivity of the silicon substrate may be reduced. The Sb element in this concentration may reduce crystalline silicon band edge energy differentiation caused by doping, and a doping ionization rate of the Sb element is high.


Examples and comparative examples


1. Obtaining of an initial formula


A silicon substrate is first prepared by using a conventional method in this field, and silicon substrates in which concentrations of antimony are 8.00E+16 cm$^{-3}$, 1.00E+16 cm$^{-3}$, 2.40E+15 cm$^{-3}$, 9.00E+14 cm$^{-3}$, 4.50E+14 cm$^{-3}$, 3.00E+14 cm$^{-3}$, 2.20E+14 cm$^{-3}$, and 4.40E+13 cm$^{-3}$ are detected and selected by adjusting a doping amount of an Sb dopant. The concentration of antimony in the silicon substrate is detected by using a conventional method in this field.

The silicon substrate is prepared into a cell, and different grid line densities are set to test cell performance respectively.

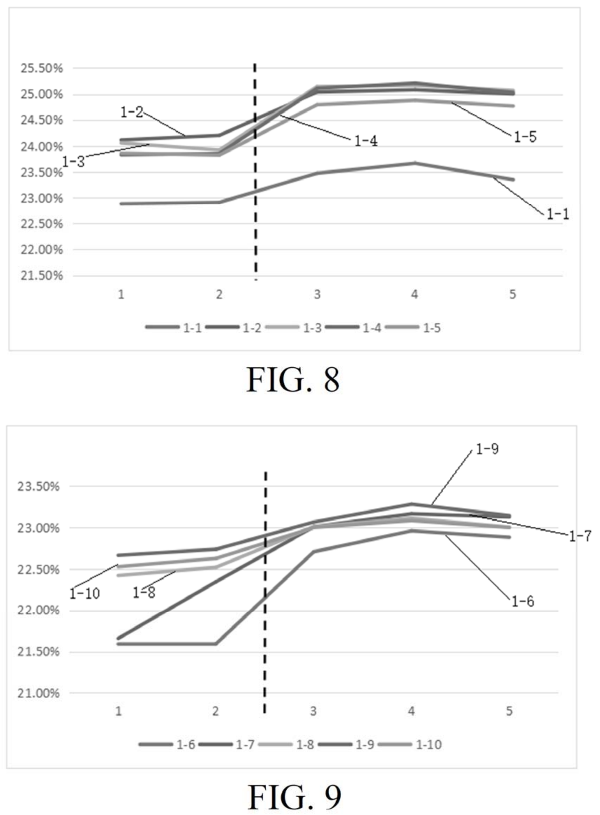

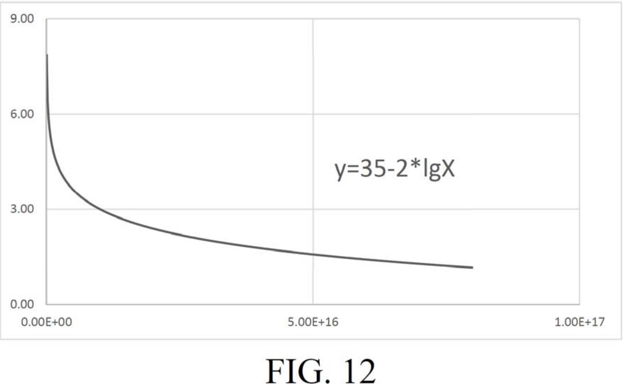

For silicon substrates with the same antimony concentration, FIG. 8 to FIG. 11 show distribution of cell efficiency with different grid line densities, that is, trend charts of cell performance (conversion efficiency Eta is used as a standard) with different grid line densities of the same silicon substrate, where FIG. 8 shows a distribution diagram of cell efficiency with different grid line densities of silicon substrates with the same antimony concentration when a thickness of the double-sided contact cell is 150 $\mu$m, and FIG. 9 shows a distribution diagram of cell efficiency with different grid line densities of silicon substrates with the same antimony concentration when a thickness of the double-sided contact cell is 100 $\mu$m. It may be found that within a specific range, as the grid line density decreases, the electrical performance is in a descending trend. In addition, below a specific grid line density, a decreasing speed of the electrical performance becomes very fast. The specific grid line density is denoted as an inflection point grid line density. Data fitting is then performed based on different antimony concentrations and corresponding inflection point grid line densities n, and results are shown in FIG. 12.

As shown in FIG. 12, a horizontal coordinate indicates a doping concentration a of antimony in the silicon substrate, and a unit thereof is cm$^{-3}$; and a vertical coordinate indicates a grid line density n, and a unit thereof is /cm. It may be seen that, a formula of an obtained fitting curve is y=35-2lg x, that is, n=35-2lg a; and when n and a meets the formula 35-2lg a, that is, when n≥35-2lg a, the efficiency of the solar cell is increased significantly, and if n<35-2lg a, the efficiency of the solar cell is decreased significantly.

It may be seen that, when the grid line density n of an actual cell is greater than the lower limit critical value (35-2lg a), the electrical performance is in a significantly high level; and when n of the actual cell is less than the lower limit critical value, the electrical performance is in a relatively low level.


2. Verification of solar cell performance

Preparation example

A silicon substrate is first prepared by using a conventional method in this field, and silicon substrates in which concentrations of antimony are 8.00E+16 cm$^{-3}$, 1.00E+16 cm$^{-3}$, 2.40E+15 cm$^{-3}$, 9.00E+14 cm$^{-3}$, 4.50E+14 cm$^{-3}$, 3.00E+14 cm$^{-3}$, 2.20E+14 cm$^{-3}$, and 4.40E+13 cm$^{-3}$ are detected and selected by adjusting a doping amount of an Sb dopant. The concentration of antimony in the silicon substrate is detected by using a conventional method in this field.

Example 1 For a double-sided contact cell

Preparation of cells 1-1 to 1-10

The structure of a double-sided contact cell shown in FIG. 7 is prepared by using the silicon substrate doped with antimony obtained through the preparation example respectively, and the cell is a TOPCon solar cell, where a silicon substrate whose concentration of antimony is 8.00E+16 cm$^{-3}$ is used in Example 1-1 and Example 1-6, a silicon substrate whose concentration of antimony is 1.00E+16 cm$^{-3}$ is used in Example 1-2 and Example 1-7, a silicon substrate whose concentration of antimony is 9.00E+14 cm$^{-3}$ is used in Example 1-3 and Example 1-8, a silicon substrate whose concentration of antimony is 8.00E+14 cm$^{-3}$ is used in Example 1-4 and Example 1-9, and a silicon substrate whose concentration of antimony is 4.00E+14 cm$^{-3}$ is used in Example 1-5 and Example 1-10. Thicknesses of the silicon substrates in Example 1-1 to Example 1-5 are 150 $\mu$m; and thicknesses of the silicon substrates in Example 1-6 to Example 1-10 are 100 $\mu$m.

For the solar cells prepared in Example 1-1 to Example 1-10, an IV tester, specifically, a photovoltaic electrical performance test device produced by Company halm is used for testing. When test samples are prepared, in each group, 100 experimental cells are prepared, a quantity of final finished product solar cells ranges from 30 to 100, and performance including Isc, Uoc, FF, and Eta is obtained by calculating a median value of the efficiency of each group, where tests are respectively shown in Table 1 and Table 2.

Table 1 Results of double-sided contact cells with a thickness of 150 $\mu$m

| Example 1 | Concentration of antimony | Formula | Grid line density n/cm | Whether Formula is met | Cell performance | | | |
|---|---|---|---|---|---|---|---|---|
| | | | | | Isc | Uoc | FF | Eta |
| 1-1 | 8.00E+16 | 35-2lg a | 1 | No | 38.25 | 0.726 | 82.4 | 22.88% |
| | | | 1.1 | No | 38.25 | 0.726 | 82.5 | 22.91% |
| | | | 1.3 | 1.3 is greater than 1.19, so that Formula is met | 38.24 | 0.729 | 84.2 | 23.47% |
| | | 35-2lg a+0.33 | 1.6 | 1.6 is greater than 1.53, so that Formula is met | 38.51 | 0.729 | 84.3 | 23.67% |
| | | 35-lg a | 17 | 17 is less than 18.1, so that Formula is met | 38.15 | 0.726 | 84.3 | 23.35% |
| 1-2 | 1.00E+16 | 35-2lg a | 1 | No | 40.9 | 0.726 | 81.2 | 24.11% |
| | | | 2 | No | 40.8 | 0.726 | 81.7 | 24.20% |
| | | | 3.2 | 3.2 is greater than 3, so that Formula is met | 40.73 | 0.731 | 84.1 | 25.04% |
| | | 35-2lg a+0.33 | 3.5 | 3.5 is greater than 3.33, so that Formula is met | 40.69 | 0.732 | 84.2 | 25.08% |
| | | 35-lg a | 18 | 18 is less than 19, so that Formula is | 40.41 | 0.731 | 84.6 | 25.00% |
| | | | | met | | | | |

(continued)

| Example 1 | Concentration of antimony | Formula | Grid line density n/cm | Whether Formula is met | Cell performance | | | |
|---|---|---|---|---|---|---|---|---|
| | | | | | Isc | Uoc | FF | Eta |
| 1-3 | 9.00E+14 | 35-2lg a | 4 | No | 41.33 | 0.734 | 79.3 | 24.06% |
| | | | 5 | No | 41.21 | 0.731 | 79.4 | 23.92% |
| | | | 5.2 | 5.2 is greater than 5.09, so that Formula is met | 40.94 | 0.732 | 83.9 | 25.14% |
| | | 35-2lg a+0.33 | 5.6 | 5.6 is greater than 5.42, so that Formula is met | 40.78 | 0.732 | 84.3 | 25.16% |
| | | 35-lg a | 19 | 19 is less than 20.1, so that Formula is met | 40.58 | 0.731 | 84.5 | 25.07% |
| 1-4 | 8.00E+13 | 35-2lg a | 6 | No | 41.27 | 0.729 | 79.2 | 23.83% |
| | | | 7 | No | 41.2 | 0.73 | 79.3 | 23.85% |
| | | | 7.3 | 7.3 is greater than 7.19, so that Formula is met | 41.06 | 0.735 | 83.2 | 25.11% |
| | | 35-2lg a+0.33 | 7.6 | 7.6 is greater than 7.53, so that Formula is met | 40.98 | 0.734 | 83.8 | 25.21% |
| | | 35-lg a | 20 | 20 is less than 21.1, so that Formula is met | 40.66 | 0.731 | 84.2 | 25.03% |
| 1-5 | 4.00E+13 | 35-2lg a | 6 | No | 41.26 | 0.732 | 79 | 23.86% |
| | | | 7 | No | 41.31 | 0.729 | 79.1 | 23.82% |
| | | | 8 | 8 is greater than 7.80, so that Formula is met | 41.15 | 0.733 | 82.2 | 24.79% |
| | | 35-2lg a+0.33 | 8.5 | 8.5 is greater than 8.13, so that Formula is met | 40.66 | 0.731 | 83.7 | 24.88% |
| | | 35-lg a | 21 | 21 is less than 21.4, so that Formula is met | 40.31 | 0.728 | 81.4 | 24.77% |

Table 2 Results of double-sided contact cells with a thickness of 100 $\mu$m

| Example 1 | Concentration of antimony | Formula | Quantity n of grid lines in unit length cm | Whether Formula is met | Cell performance | | | |
|---|---|---|---|---|---|---|---|---|
| | | | | | Isc | Uoc | FF | Eta |
| 1-6 | 8.00E+16 | 35-2lg a | 1 | No | 36.07 | 0.729 | 82.1 | 21.59% |
| | | | 1.1 | No | 36.03 | 0.729 | 82.2 | 21.59% |
| | | | 1.3 | 1.3 is greater than 1.19, so that Formula is met | 37.11 | 0.731 | 83.7 | 22.71% |
| | | 35-2lg a+0.5 | 1.8 | 1.8 is greater than 1.69, so that Formula is met | 37.33 | 0.733 | 83.9 | 22.96% |
| | | 35-lg a | 17 | 17 is less than 18.1, so that Formula is met | 37.04 | 0.731 | 84.5 | 22.88% |

(continued)

| Example 1 | Concentration of antimony | Formula | Quantity n of grid lines in unit length cm | Whether Formula is met | Cell performance | | | |
|---|---|---|---|---|---|---|---|---|
| | | | | | Isc | Uoc | FF | Eta |
| 1-7 | 1.00E+16 | 35-2lg a | 1 | No | 36.09 | 0.73 | 82.2 | 21.66% |
| | | | 2 | No | 37.05 | 0.731 | 82.5 | 22.34% |
| | | | 3.2 | 3.2 is greater than 3, so that Formula is met | 37.59 | 0.733 | 83.5 | 23.01% |
| | | 35-2lg a+0.5 | 3.8 | 3.8 is greater than 3.5, so that Formula is met | 37.71 | 0.733 | 83.8 | 23.16% |
| | | 35-lg a | 18 | 18 is less than 19, so that Formula is met | 37.52 | 0.732 | 84.2 | 23.13% |
| 1-8 | 9.00E+14 | 35-2lg a | 4 | No | 37.22 | 0.731 | 82.4 | 22.42% |
| | | | 5 | No | 37.17 | 0.729 | 83.1 | 22.52% |
| | | | 5.2 | 5.2 is greater than 5.09, so that Formula is met | 37.39 | 0.731 | 84.2 | 23.01% |
| | | 35-2lg a+0.5 | 5.7 | 5.7 is greater than 5.59, so that Formula is met | 37.26 | 0.734 | 84.5 | 23.11% |
| | | 35-lg a | 19 | 19 is less than 20.1, so that Formula is met | 37.04 | 0.734 | 84.6 | 23.00% |
| 1-9 | 8.00E+13 | 35-2lg a | 6 | No | 37.71 | 0.732 | 82.1 | 22.66% |
| | | | 7 | No | 37.74 | 0.732 | 82.3 | 22.74% |
| | | | 7.3 | 7.3 is greater than 7.19, so that Formula is met | 37.954 | 0.733 | 82.9 | 23.06% |
| | | 35-2lg a+0.5 | 8 | 8 is greater than 7.69, so that Formula is met | 38.07 | 0.735 | 83.2 | 23.28% |
| | | 35-lg a | 20 | 20 is less than 21.1, so that Formula is met | 37.54 | 0.733 | 84.1 | 23.14% |

(continued)

| Example 1 | Concentration of antimony | Formula | Quantity n of grid lines in unit length cm | Whether Formula is met | Cell performance | | | |
|---|---|---|---|---|---|---|---|---|
| | | | | | Isc | Uoc | FF | Eta |
| 1-10 | 4.00E+13 | 35-2lg a | 6 | No | 37.71 | 0.732 | 81.6 | 22.52% |
| | | | 7 | No | 37.74 | 0.732 | 81.9 | 22.63% |
| | | | 8 | 8 is greater than 7.80, so that Formula is met | 37.84 | 0.734 | 82.8 | 23.00% |
| | | 35-2lg a+0.5 | 9.0 | 9.0 is greater than 8.3, so that Formula is met | 37.88 | 0.735 | 82.9 | 23.08% |
| | | 35-lg a | 21 | 21 is less than 21.4, so that Formula is met | 37.49 | 0.732 | 83.8 | 23.00% |

It may be seen based on the results of Example 1 that, in a case that the solar cell is a double-sided contact cell, that is, a positive electrode and a negative electrode of the cell are distributed on two different surfaces of the cell, when a relationship between the grid line density n and the doping concentration of antimony a does not meet Formula 1, the performance including Isc, Uoc, FF, and Eta of the solar cell is not good; as the grid line density increases, when the relationship between the grid line density n and the doping concentration of antimony a meets Formula 1, the performance including Isc, Uoc, FF, and Eta of the solar cell is good; and when the relationship between the grid line density n and the doping concentration of antimony a meets Formula 2, the performance including Isc, Uoc, FF, and Eta of the solar cell is better.

For data in Table 1, under different concentrations, a trend chart of data of the Eta performance obtained according to an increasing order of grid line densities in this Example is shown in FIG. 8; and for data in Table 2, under different concentrations, a trend chart of data of the Eta performance obtained according to an increasing order of grid line densities in this Example is shown in FIG. 9. It should be noted that, horizontal coordinates in FIG. 8 and FIG. 9 only indicate a data serial number of the grid line density in this Example and have no physical meaning.

In FIG. 8 and FIG. 9, data on a left side of the vertical dashed line does not meet Formula 1, and it may be seen that in a case that Formula 1 is not meet, the cell performance is decreased quickly.

Example 2 For a back contact cell

Preparation of cells 2-1 to 2-10

A structure of a back contact cell is prepared by using the silicon substrate doped with antimony obtained through the preparation example respectively, where the cell structure is shown in FIG. 1, and the grid line structure is shown in FIG. 2. A silicon substrate whose concentration of antimony is 8.00E+16 $cm^{-3}$ is used in Example 2-1 and Example 2-6, a silicon substrate whose concentration of antimony is 1.00E+16 $cm^{-3}$ is used in Example 2-2 and Example 2-7, a silicon substrate whose concentration of antimony is 9.00E+14 $cm^{-3}$ is used in Example 2-3 and Example 2-8, a silicon substrate whose concentration of antimony is 8.00E+14 $cm^{-3}$ is used in Example 2-4 and Example 2-9, a silicon substrate whose concentration of antimony is 4.00E+14 $cm^{-3}$ is used in Example 2-5 and Example 2-10, and thicknesses of different silicon substrates and depths of isolating regions of different back contact cells are respectively based.

For the solar cells prepared in Example 2-1 to Example 2-10, performance including Isc, Uoc, FF, and Eta is detected by using a method the same as that of Example 1, and results are respectively shown in Table 3 and Table 4.

Table 3 Results of back contact cells with a thickness of 150 μm

| Example 2 | Concentration of antimony | Formula | Quantity n of grid lines in unit length cm | Whether Formula is met | Cell performance | | | |
|---|---|---|---|---|---|---|---|---|
| | | | | | Isc | Uoc | FF | Eta |
| 2-1 | 8.00E+16 | 35-1.9lg a | 2 | No | 38.25 | 0.726 | 82.4 | 22.88% |
| | | | 3 | 3 is greater than 2.88, so that Formula is met | 39.19 | 0.735 | 84.4 | 24.31% |
| | | 35-1.9lg a+0.33 | 3.3 | 3.3 is greater than 3.21, so that Formula is met | 39.18 | 0.735 | 84.5 | 24.33% |
| | | 35-1.9lg a+0.34 (d=1 μm) | 3.4 | 3.4 is greater than 3.22, so that Formula is met | 39.18 | 0.736 | 84.6 | 24.40% |
| | | 35-1.9lg a+0.36 (d=10 μm) | 3.4 | 3.4 is greater than 3.24, so that Formula is met | 39.14 | 0.736 | 84.6 | 24.37% |
| | | 35-lg a | 17 | 17 is less than 18.1, so that Formula is met | 39.11 | 0.731 | 84.7 | 24.22% |
| 2-2 | 1.00E+16 | 35-1.9lg a | 4 | No | 41.73 | 0.737 | 82.5 | 25.37% |
| | | | 4.8 | 4.8 is greater than 4.60, so that Formula is met | 41.93 | 0.739 | 84.3 | 26.12% |
| | | 35-1.9lg a+0.33 | 5 | 5 is greater than 4.93, so that Formula is met | 41.95 | 0.739 | 84.4 | 26.16% |
| | | 35-1.9lg a+0.34 (d=1 μm) | 5.1 | 5.1 is greater than 4.94, so that Formula is met | 41.94 | 0.739 | 84.5 | 26.19% |
| | | 35-1.9lg a+0.36 (d=10 μm) | 5.2 | 5.2 is greater than 4.96, so that Formula is met | 41.93 | 0.739 | 84.5 | 26.18% |
| | | 35-lg a | 18 | 18 is less than 19, so that Formula is met | 41.82 | 0.734 | 84.7 | 26.00% |

(continued)

| Example 2 | Concentration of antimony | Formula | Quantity n of grid lines in unit length cm | Whether Formula is met | Cell performance | | | |
|---|---|---|---|---|---|---|---|---|
| | | | | | Isc | Uoc | FF | Eta |
| 2-3 | 9.00E+14 | 35-1.9lg a | 6 | No | 41.71 | 0.735 | 82.7 | 25.35% |
| | | | 6.7 | 6.7 is greater than 6.59, so that Formula is met | 41.95 | 0.74 | 84.3 | 26.17% |
| | | 35-1.9lg a+0.33 | 7 | 7 is greater than 6.92, so that Formula is met | 41.91 | 0.741 | 84.4 | 26.21% |
| | | 35-1.9lg a+0.34 (d=1 μm) | 7.1 | 6.1 is greater than 6.93, so that Formula is met | 41.91 | 0.741 | 84.5 | 26.24% |
| | | 35-1.9lg a+0.36 (d=10 μm) | 7.2 | 6.2 is greater than 6.95, so that Formula is met | 41.87 | 0.741 | 84.5 | 26.22% |
| | | 35-lg a | 19 | 19 is less than 20.1, so that Formula is met | 41.76 | 0.738 | 84.5 | 26.04% |
| 2-4 | 8.00E+13 | 35-1.9lg a | 8 | No | 41.76 | 0.736 | 82.5 | 25.36% |
| | | | 8.8 | 8.8 is greater than 8.58, so that Formula is met | 41.96 | 0.741 | 83.8 | 26.06% |
| | | 35-1.9lg a+0.33 | 9 | 9 is greater than 8.92, so that Formula is met | 41.97 | 0.741 | 83.9 | 26.09% |
| | | 35-1.9lg a+0.34 (d=1 μm) | 9.1 | 9.1 is greater than 8.93, so that Formula is met | 41.94 | 0.741 | 83.9 | 26.07% |
| | | 35-1.9lg a+0.36 (d=10 μm) | 9.2 | 9.2 is greater than 8.95, so that Formula is met | 41.95 | 0.741 | 83.9 | 26.08% |
| | | 35-lg a | 20 | 20 is less than 21.1, so that Formula is met | 41.64 | 0.739 | 84.5 | 26.00% |

(continued)

| Example 2 | Concentration of antimony | Formula | Quantity n of grid lines in unit length cm | Whether Formula is met | Cell performance | | | |
|---|---|---|---|---|---|---|---|---|
| | | | | | Isc | Uoc | FF | Eta |
| 2-5 | 4.00E+13 | 35-1.9lg a | 9 | No | 41.58 | 0.736 | 82.6 | 25.28% |
| | | | 9.3 | 9.3 is greater than 9.16, so that Formula is met | 41.91 | 0.742 | 83.6 | 26.00% |
| | | 35-1.9lg a+0.33 | 9.7 | 9.7 is greater than 9.49, so that Formula is met | 41.9 | 0.742 | 83.7 | 26.02% |
| | | 35-1.9lg a+0.34 (d=1 μm) | 9.8 | 9.8 is greater than 9.50, so that Formula is met | 41.89 | 0.742 | 83.7 | 26.02% |
| | | 35-1.9lg a+0.36 (d=10 μm) | 9.9 | 9.9 is greater than 9.52, so that Formula is met | 41.89 | 0.742 | 83.8 | 26.05% |
| | | 35-lg a | 21 | 21 is less than 21.4, so that Formula is met | 41.51 | 0.74 | 84.2 | 25.86% |

Table 4 Results of back contact cells with a thickness of 100 μm

| Example 2 | Concentration of antimony | Formula | Quantity n of grid lines in unit length cm | Whether Formula is met | Cell performance | | | |
|---|---|---|---|---|---|---|---|---|
| | | | | | Isc | Uoc | FF | Eta |
| 2-6 | 8.00E+16 | 35-1.91g a | 2 | No | 36.55 | 0.734 | 81 | 21.73% |
| | | | 3 | 3 is greater than 2.88, so that Formula is met | 36.96 | 0.734 | 82.9 | 22.49% |
| | | 35-1.9lg a+0.5 | 3.5 | 3.5 is greater than 3.38, so that Formula is met | 37.01 | 0.733 | 83.2 | 22.57% |
| | | 35-1.91g a+0.51 (d=1 μm) | 3.6 | 3.6 is greater than 3.39, so that Formula is met | 37.02 | 0.733 | 83.3 | 22.60% |
| | | 35-1.9lg a+0.56 (d=10 μm) | 3.7 | 3.7 is greater than 3.44, so that Formula is met | 37.01 | 0.733 | 83.4 | 22.63% |
| | | 35-lg a | 17 | 17 is less than 18.1, so that Formula is met | 36.86 | 0.725 | 84.1 | 22.47% |

(continued)

| Example 2 | Concentration of antimony | Formula | Quantity of grid lines in unit length cm | Whether Formula is met | Cell performance | | | |
|---|---|---|---|---|---|---|---|---|
| | | | | | Isc | Uoc | FF | Eta |
| 2-7 | 1.00E+16 | 35-1.9lg a | 4 | No | 37.76 | 0.729 | 82.9 | 22.82% |
| | | | 4.8 | 4.8 is greater than 4.60, so that Formula is met | 38.03 | 0.731 | 83.7 | 23.27% |
| | | 35-1.9lg a+0.5 | 5.2 | 5.2 is greater than 5.1, so that Formula is met | 38.09 | 0.731 | 83.8 | 23.33% |
| | | 35-1.9lg a+0.51 (d=1 $\mu$m) | 5.3 | 5.3 is greater than 5.11, so that Formula is met | 38.07 | 0.731 | 83.9 | 23.35% |
| | | 35-1.9lg a+0.56 (d=10 $\mu$m) | 5.4 | 5.4 is greater than 5.16, so that Formula is met | 38.07 | 0.73 | 83.9 | 23.32% |
| | | 35-lg a | 18 | 18 is less than 19, so that Formula is met | 37.89 | 0.723 | 84.2 | 23.07% |
| 2-8 | 9.00E+14 | 35-1.9lg a | 6 | No | 38.05 | 0.729 | 83.1 | 23.05% |
| | | | 6.7 | 6.7 is greater than 6.59, so that Formula is met | 38.53 | 0.73 | 83.9 | 23.61% |
| | | 35-1.9lg a+0.5 | 7.2 | 7.2 is greater than 7.09, so that Formula is met | 38.75 | 0.729 | 84.1 | 23.76% |
| | | 35-1.9lg a+0.51 (d=1 $\mu$m) | 7.3 | 7.3 is greater than 7.1, so that Formula is met | 38.71 | 0.729 | 84.2 | 23.76% |
| | | 35-1.91g a+0.56 (d=10 $\mu$m) | 7.4 | 7.4 is greater than 7.14, so that Formula is met | 38.67 | 0.729 | 84.2 | 23.74% |
| | | 35-lg a | 19 | 19 is less than 20.1, so that Formula is met | 38.24 | 0.722 | 84.4 | 23.30% |

(continued)

| Example 2 | Concentration of antimony | Formula | Quantity n of grid lines in unit length cm | Whether Formula is met | Cell performance | | | |
|---|---|---|---|---|---|---|---|---|
| | | | | | Isc | Uoc | FF | Eta |
| 2-9 | 8.00E+13 | 35-1.9lg | 8 | No | 38.14 | 0.725 | 82.7 | 22.87% |
| | | | 8.8 | 8.8 is greater than 8.58, so that Formula is met | 38.32 | 0.725 | 83.2 | 23.11% |
| | | 35-1.9lg a+0.5 | 9.2 | 9.2 is greater than 9.08, so that Formula is met | 38.31 | 0.727 | 83.3 | 23.20% |
| | | 35-1.9lg a+0.51 (d=1 $\mu$m) | 9.3 | 9.3 is greater than 9.09, so that Formula is met | 38.35 | 0.726 | 83.3 | 23.20% |
| | | 35-1.91g a+0.56 (d=10 $\mu$m) | 9.4 | 9.4 is greater than 9.14, so that Formula is met | 38.29 | 0.726 | 83.4 | 23.18% |
| | | 35-lg a | 20 | 20 is less than 21.1, so that Formula is met | 37.75 | 0.726 | 84.1 | 23.05% |
| 2-10 | 4.00E+13 | 35-1.91g a | 9 | No | 37.87 | 0.721 | 80.3 | 21.93% |
| | | | 9.3 | 9.3 is greater than 9.16, so that Formula is met | 37.92 | 0.723 | 81.5 | 22.34% |
| | | 35-1.91g a+0.5 | 9.8 | 9.8 is greater than 9.66, so that Formula is met | 37.94 | 0.723 | 82.2 | 22.55% |
| | | 35-1.9lg a+0.51 (d=1 $\mu$m) | 9.9 | 9.9 is greater than 9.67, so that Formula is met | 37.92 | 0.721 | 82.1 | 22.45% |
| | | 35-1.9lg a+0.56 (d=10 $\mu$m) | 10 | 10 is greater than 9.72, so that Formula is met | 37.91 | 0.721 | 82.4 | 22.52% |
| | | 35-lg a | 21 | 21 is less than 21.4, so that Formula is met | 37.88 | 0.721 | 82.5 | 22.53% |

It may be seen based on the results in Table 3 and Table 4 that, in a case that the solar cell is a back contact cell, that is, a positive electrode and a negative electrode of the cell are both located on a surface of the cell, when n≥35-1.9lg a, the performance including Isc, Uoc, FF, and Eta of the solar cell is good, and when this formula is not met, the performance including Isc, Uoc, FF, and Eta is poor.

In addition, when n meets Formula 2, the performance including Isc, Uoc, FF, and Eta of the solar cell is better. A reason for this case may be that, carriers need to pass through the silicon substrate in the thickness direction, and generally also need to move transversely between the positive electrode and the negative electrode on the back surface, and a path through which the carriers pass is longer in a transverse transmission process of the carriers, so that more grid lines need to be arranged in a unit length to offset this influence.

When n meets Formula 4, the performance including Isc, Uoc, FF, and Eta of the solar cell can be further improved.

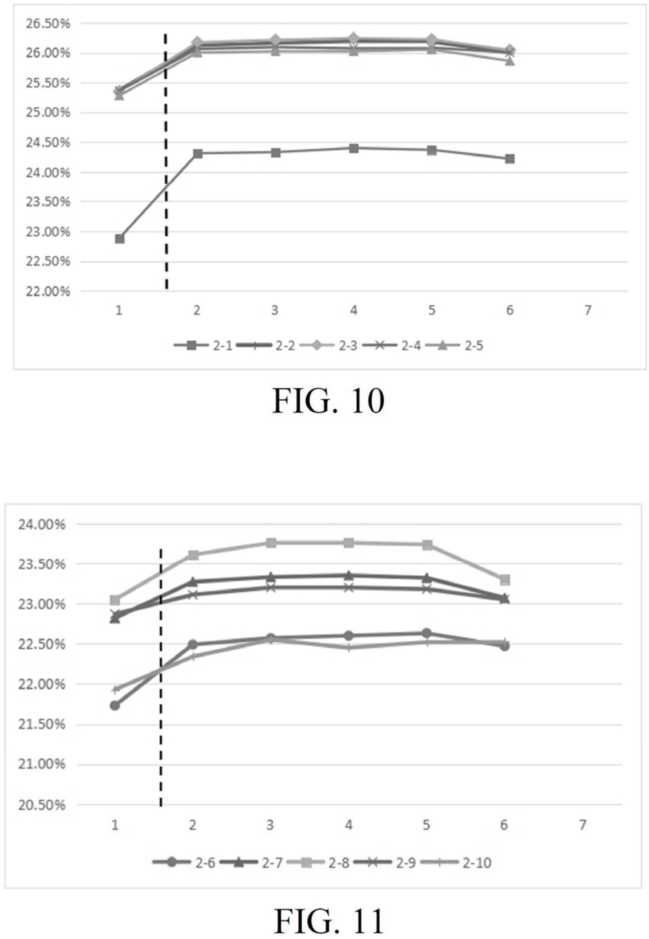

For data in Table 3, under different concentrations, a trend chart of data of the Eta performance obtained according to an increasing order of grid line densities in this Example is shown in FIG. 10; and For data in Table 4, under different concentrations, a trend chart of data of the Eta performance obtained according to an increasing order of grid line densities in this Example is shown in FIG. 11; and It should be noted that, horizontal coordinates in FIG. 10 and FIG. 11 only indicate a data serial number of the grid line density in this Example and have no physical meaning.

In FIG. 10 and FIG. 11, data on a left side of the vertical dashed line does not meet Formula 1, and it may be seen more clearly that in a case that Formula 1 is not meet, the cell performance is decreased quickly.

Although the embodiments of the present application are described with reference to the foregoing, the present application is not limited to the foregoing embodiments and application fields, and the foregoing embodiments are merely exemplary and instructive rather than limitative. A person of ordinary skill in the art can further make many forms under the teaching of this specification without departing from the protection scope of the claims of the present application, and all the forms fall within the protection scope of the present application.

**Claims**

1. A solar cell, comprising:

   a silicon substrate, and a plurality of fingers formed on a surface of the silicon substrate, wherein the plurality of fingers extend in the same direction;
   the silicon substrate is doped with antimony; and
   when a density of fingers with the same polarity in a direction perpendicular to the extending direction of the plurality of fingers is n/cm and a concentration of antimony in the silicon substrate is a atom/cm$^3$, n and a meet the following relationship:

   $$n \geq 35 - k\lg a,$$

   wherein
   k is a constant less than or equal to 2.

2. The solar cell according to claim 1, wherein when a thickness of the silicon substrate of the solar cell is b $\mu$m, n meets the following relationship:

   $$n \geq 35 - k\lg a + \frac{c}{b},$$

   wherein
   c is a constant and a value is 50 $\mu$m.

3. The solar cell according to claim 2, wherein n and a further meet the following relationship:

   $$n \leq 35 - \lg a$$

4. The solar cell according to any one of claims 1 to 3, wherein when the solar cell is a double-sided contact solar cell, k=2.

5. The solar cell according to any one of claims 1 to 3, wherein when the solar cell is a back contact solar cell, k=1.9.

6. The solar cell according to claim 5, wherein the surface of the silicon substrate comprises an electron collection region, a hole collection region, and an isolating region located between the electron collection region and the hole collection region; and when a depth of the isolating region is d $\mu$m, n meets the following relationship:

   $$n \geq 35 - 1.9\lg a + \frac{c}{b-d}.$$

7. The solar cell according to claim 6, wherein

   the depth of the isolating region is a height difference corresponding to an average depth from a bottom of a region having a higher absolute height of the electron collection region and the hole collection region to a bottom of the isolating region, and the bottom of the isolating region is a surface of the silicon substrate corresponding to the isolating region; and

when the solar cell comprises an interface passivation layer, a bottom of the electron collection region or a bottom of the hole collection region is a surface of the interface passivation layer close to the silicon substrate.

8.  The solar cell according to any one of claims 1 to 7, wherein a ranges from 1E13 to 1E18.

9.  The solar cell according to any one of claims 1 to 8, wherein a width of each of the plurality of fingers ranges from 10 $\mu$m to 200 $\mu$m.

10. A photovoltaic module, comprising the solar cell according to any one of claims 1 to 9.

FIG. 1

FIG. 2

FIG. 3

FIG. 4

FIG. 5

**FIG. 6**

**FIG. 7**

FIG. 8

FIG. 9

FIG. 10

FIG. 11

FIG. 12

## INTERNATIONAL SEARCH REPORT

| | International application No. |
|---|---|
| | **PCT/CN2025/075167** |

| A. | CLASSIFICATION OF SUBJECT MATTER |
|---|---|

H10F77/14(2025.01)i; H10F77/20(2025.01)i; H10F10/00(2025.01)i

According to International Patent Classification (IPC) or to both national classification and IPC

| B. | FIELDS SEARCHED |
|---|---|

Minimum documentation searched (classification system followed by classification symbols)

   IPC:H10F

Documentation searched other than minimum documentation to the extent that such documents are included in the fields searched

Electronic data base consulted during the international search (name of data base and, where practicable, search terms used)

   CNABS; CNTXT; ENTXTC; WPABSC; DWPI; VEN; ENTXT; IEEE; CNKI: 太阳能电池, 硅, 基底, 锑, 掺杂, 栅线, 细栅, solar, cell, silicon, substrate, Sb, doped, gridline

| C. | DOCUMENTS CONSIDERED TO BE RELEVANT |
|---|---|

| Category* | Citation of document, with indication, where appropriate, of the relevant passages | Relevant to claim No. |
|---|---|---|
| PX | CN 118431312 A (LONGI GREEN ENERGY TECHNOLOGY CO., LTD.) 02 August 2024 (2024-08-02)<br>   entire document | 1-10 |
| Y | CN 102214719 A (SHANDONG LINUO SOLAR POWER HOLDINGS CO., LTD.) 12 October 2011 (2011-10-12)<br>   description, paragraphs [0005]-[0025], and figures 1-3 | 1, 4-5, 8-10 |
| Y | CN 103348448 A (TEIJIN LIMITED et al.) 09 October 2013 (2013-10-09)<br>   description, paragraphs [0075]-[0722], and figures 1-71 | 1, 4-5, 8-10 |
| A | CN 117637892 A (LONGI GREEN ENERGY TECHNOLOGY CO., LTD.) 01 March 2024 (2024-03-01)<br>   entire document | 1-10 |
| A | US 2012037967 A1 (INTERNATIONAL BUSINESS MACHINES CORP.) 16 February 2012 (2012-02-16)<br>   entire document | 1-10 |

☐ Further documents are listed in the continuation of Box C.    ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **17 April 2025** | **27 April 2025** |

| Name and mailing address of the ISA/CN | Authorized officer |
|---|---|
| **China National Intellectual Property Administration (ISA/CN)**<br>**China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT
### Information on patent family members

International application No.

**PCT/CN2025/075167**

| Patent document cited in search report | | | Publication date (day/month/year) | Patent family member(s) | | | Publication date (day/month/year) |
|---|---|---|---|---|---|---|---|
| CN | 118431312 | A | 02 August 2024 | CN | 118431312 | B | 17 December 2024 |
| CN | 102214719 | A | 12 October 2011 | CN | 102214719 | B | 01 May 2023 |
| CN | 103348448 | A | 09 October 2013 | TW | 201511313 | A | 16 March 2015 |
| | | | | TWI | 511315 | B | 01 December 2015 |
| | | | | KR | 20130117830 | A | 28 October 2013 |
| | | | | KR | 101386271 | B1 | 18 April 2014 |
| | | | | EP | 2650908 | A1 | 16 October 2013 |
| | | | | EP | 2650908 | A4 | 20 April 2016 |
| | | | | TW | 201251085 | A | 16 December 2012 |
| | | | | TWI | 488321 | B | 11 June 2015 |
| | | | | TW | 201511086 | A | 16 March 2015 |
| | | | | TWI | 520176 | B | 01 February 2016 |
| | | | | WO | 2012077797 | A1 | 14 June 2012 |
| | | | | US | 2013228902 | A1 | 05 September 2013 |
| | | | | US | 9577050 | B2 | 21 February 2017 |
| | | | | KR | 20130122649 | A | 07 November 2013 |
| | | | | KR | 101411808 | B1 | 25 June 2014 |
| | | | | KR | 20140032500 | A | 14 March 2014 |
| | | | | KR | 101411726 | B1 | 26 June 2014 |
| | | | | EP | 3046136 | A1 | 20 July 2016 |
| | | | | EP | 2701182 | A2 | 26 February 2014 |
| | | | | EP | 2701182 | A3 | 04 June 2014 |
| CN | 117637892 | A | 01 March 2024 | CN | 117637892 | B | 30 April 2024 |
| US | 2012037967 | A1 | 16 February 2012 | US | 8298853 | B2 | 30 October 2012 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202410461849